# EUROPEAN PATENT APPLICATION

(11) **EP 0 993 240 A1**
(43) Date of publication of application: **12.04.2000**
(21) Application number: 99307552.2
(22) Date of filing: 24.09.1999
(51) Int. Cl.: H05K 1/00, H05K 1/11

(54) **Circuit board and connection method**

(30) Priority: 25.09.1998 GB 9820932
(71) Applicant: Itron (U.K.) Limited, Great Yarmouth, Norfolk NR31 6PX (GB)
(72) Inventor: Taylor, David, Great Yarmouth, Norfolk NR31 6PX (GB); Stubbings, Andrew, Great Yarmouth, Norfolk NR31 6PX (GB)
(74) Representative: Simons, Elisabeth Anne

(57) **Abstract**

A circuit board 1 has an insulating substrate and a plurality of electrically conductive connection pads 2, 3, 4, 5, 6, 7, 8 on the substrate, for electrical connection to another device. The pads are arranged in sets with a plurality of pads in each set. The circuit board 1 further includes circuit tracks which electrically interconnect a corresponding pad in each respective set. The circuit board 1 may be subdivided to provide desired circuit configurations.

## Description

The present invention relates to a circuit board and to a method of connecting a device such as an electrical connector or electric circuit assembly to the circuit board.

There are many problems facing designers and users of electronic circuits. In particular, many electronic sub-assemblies are designed and manufactured to utilise miniature connectors for signal transmission between them. The variation in the types of such connectors and/or the spacing or pitch between the conductors of these connectors makes it frequently necessary for an adaptor cable to be produced which will enable circuit devices of different type or pitch to be interconnected. On occasions, it may be difficult to procure and or assemble such connectors. Where the direct soldering of a cable to a device is necessary, problems may arise due to the breaking of solder terminations during handling.

Certain connectors accept a flexible plastic-foil substrate typically of 0.3mm thickness which has exposed terminations which are inserted into the connector to make electrical contact. The nature of these foil substrates only allows a few insertions and withdrawals before the foil is damaged. These foils are unsuitable for production testing of products with insertion connectors.

Surface mount integrated circuits and similar components with arrays of lead pins can require to be mounted in sockets for development purposes. An EPROM memory is an example where a temporary interconnection is required to allow changing of the software code.

Often a socket is soldered with wire to pads on a printed circuit board (PCB) in order to convert Surface Mount Technology (SMT) devices to a "through hole" pin device. The terminations to the PCB often short circuit or become detached during handling.

Many devices use a 2.54mm pitch interconnecting system. Flexible wire cables for mating with these connectors use "Insulation Displacement" and have a wire pitch of 1.27mm. Where correct terminations are not available cables may have to be soldered to the exposed pitch pins of a connector. Difficulties may be encountered because of the very close spacing of the pins and connectors. "In-line" testing may be difficult unless these connectors can be suitably terminated and or interconnected.

Electronic devices are often supplied with terminations which are unique compared to the current designs of a particular user. Satisfactory testing of an integrated circuit with pins on two or more sides often requires a dedicated pad layout or careful link wire attachment.

The present invention seeks to overcome many of the difficulties facing designers or users of electronic devices by providing a versatile, single substrate which may be utilised in the manner to be described to enable a variety of interconnections to be made between devices readily, securely, reliably and repeatedly.

In its most general form, the invention provides a circuit board comprising an insulating substrate; a plurality of electrically conductive connection pads on the substrate, for electrical connection to another device (such as to another circuit or circuit component), the pads being arranged in sets with a plurality of pads in each set; and circuit tracks on the circuit board electrically interconnecting a corresponding pad in each respective set; whereby the circuit board may be subdivided to provide desired circuit configurations.

So that the circuit board may selectively accommodate circuit components having connectors spaced at various pitches, preferably the pitch of the pads in at least two sets differs from one set to the other; indeed the pitch of the pads is advantageously different in each set.

According to need, at least 3, preferably at least 4, 5, 6 or even more sets of pads may be provided. Likewise, at least 3, or at least 5 or at least 10 or at least 20, pads may be provided per set.

In order to provide flexibility, the circuit board is advantageously thin enough to be cut by scissors so as to enable selective division of the circuit board, although it is preferably still sufficiently firm as not to break under all but excessive deformation. To this end, the substrate may be made of fibre glass.

To enable the circuit board to be subdivided in the most efficient manner, the tracks preferably extend generally in the same direction along the circuit board.

The pads and tracks may be provided on both faces of the circuit board.

To enable the board to be used to its maximum capacity, those areas of the substrate not provided with pads or circuit tracks are preferably provided with solder resist.

Where other devices, such as circuit components or assemblies, are to be attached physically as well as electrically to the circuit board, it is preferable for there to be provided further pads on the face or faces of the board, not electrically connected to any of the other pads or tracks, to enable conductive mounting supports on devices intended to be mounted on the circuit board to be mechanically attached. Hence preferably at least one further pad not electrically connected to any of the other pads or tracks is provided to enable a device to be mechanically attached to the circuit board.

In order for the electrical connections to the circuit board to be made reliably, the pads are preferably of tin/lead solder, tin, nickel, gold or silver.

In another aspect, the invention also encompasses a method of connecting a device (such as an electrical connector or electric circuit) to a circuit board as aforesaid, comprising cutting the circuit board to a desired shape, and connecting the device to the circuit board.

Preferably, the device has at least one plurality of circuit connectors arranged substantially in a row of constant pitch and the circuit board has at least one set of pads having the same pitch as said pitch, and in the cutting step the circuit board is cut so as to expose at the cut edge an array of pads having the same pitch as the said pitch, and in the connecting step the circuit connectors are connected to the said pads.

The invention further provides an electrical assembly comprising at least one circuit board as aforesaid and connected to a device such as an electrical connector.

In order to provide multiple access to a device connected to the electrical connector in the previous paragraph, the electrical assembly advantageously comprises two circuit boards as specified in any of the preceding paragraphs arranged back to back and inserted in a dual-in-line, insulation displacement connector header whereby to provide multiple inter-connections.

The invention extends to a kit of parts comprising at least one circuit board as aforesaid and a device compatible with at least one such set of pads.

The invention therefore can present the opportunity for selective areas of the board to be cut to provide a variety of configurations by which cables and/or connectors of different pitch may be interconnected, either by solder or by press fitting into suitable receptacles provided in or on the board.

The user who retains such a circuit board in stock may avoid the need to retain a wide range of different connecting devices, some of which may never be used, or alternatively may avoid the need to wait for delivery of a suitable version for the desired application.

The thinness of the board can permit it to be readily trimmed to suit the nature of the connection or to accommodate direct insertion of the board into a connector. The circuit board may even be soldered at angles approaching 90 degrees to the matching pads of another circuit board which may or may not be of the same design as used in the present invention.

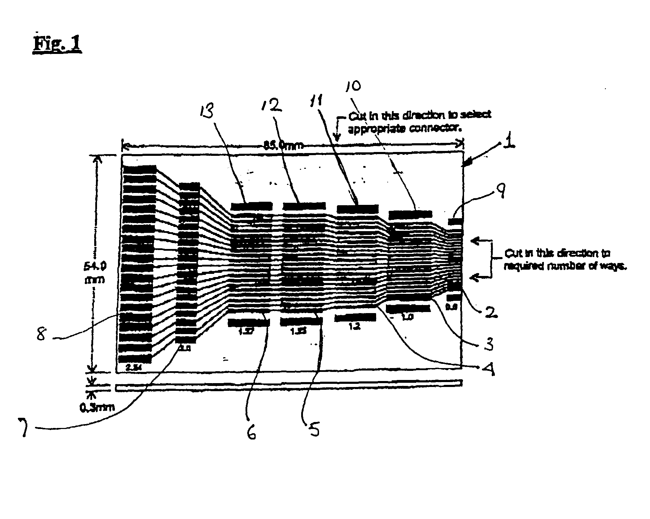

The preferred embodiments of the invention will now be described with reference to the single figure of the drawings which illustrates a typical configuration of connection pads on a single circuit board.

The drawing shows one side of a printed circuit board 1 which, as illustrated, is of size 85.0mm by 54.0mm (that is credit card size) but may be of any other convenient size. In this particular example, on one face, are shown arrays (sets) of connecting pads 2 through 8 inclusive. The size of the pads and their pitch varies from one array to the next. As illustrated the pads at the right hand side of the circuit board have a pitch of 0.8mm, increasing through values of 1.0, 1.2, 1.25, 1.27, 2.0 and, on the left hand side, 2.54mm (although naturally other pitches could be used according to requirement). There are 20 pads in each array. The corresponding pads from one array to the next are interconnected so as to create 20 separate circuit paths (isolated from one another) extending from one array adjacent one edge of the circuit board and ending at the array adjacent the opposite edge of the circuit board.

Conventional techniques are used for forming the pads and interconnecting tracks on the face of the circuit board. If required the same or a different configuration of tracks and pads could be provided on the opposite face of the circuit board. The width of the pads and of the interconnecting tracks are designed to be sufficient for the intended current while, at the same time, there is adequate isolation of the tracks and pads and low capacitance between them.

The circuit board could be made of fibre glass, a material capable of sustaining solder temperatures. The pads may be of solder (tin/lead), tin, nickel, gold, silver or any other suitable conductive material. For convenience the pitch of each array may be labelled on the circuit board adjacent the array. Additional pads such as those labelled 9 through 13 may be provided adjacent the respective arrays 2 through 6 but not electrically interconnected. They may be used to solder to metal mounting supports on connectors or other circuits in order to provide mechanical strength and support.

The thickness for the circuit board 1 is 0.3mm, to enable it to flex or to be cut by scissors, although other thicknesses, such as in the range 0.1 to 0.5mm, may be employed. Boards may be cut in a direction generally parallel to the connecting tracks so as to divide the circuit board into a number of separate ways. Alternatively or in addition the board may be cut generally at right angles to the tracks so as to select which arrays are appropriate for a particular use. Areas of the circuit board not carrying either pads or tracks can nevertheless carry a solder resist and may be used for mounting other components or devices on the surface or by means of through holes provided in the board.

There are many ways in which the circuit board can be used to make a variety of interconnections. Exemplary uses are indicated below but the skilled man will be able to apply his own ingenuity to utilise the inventive circuit board to suit his own particular circumstances.

The variety of pitch between adjacent pads has already been mentioned. However, the pads in each respective array are preferably long enough to accommodate at least two connectors of the same pitch. The circuit board may be cut to provide or accommodate a transition from 16 ways, for example, to a separate 10 way circuit and a 6 way circuit. The board may therefore be used for "in-line" testing. On occasions, it may be advantageous for connections to the 10 way and 6 way circuits to be made on different sets of pads.

Two circuit boards may be placed back to back and soldered to a Dual-In-Line (DIL) Insulation Displacement Connector (IDC) Header to allow multiple interconnections to be made from each to another DIL device, whether a connector or integrated circuit, or to several Single-In-Line (SIL) devices on both or either of the circuit boards. Similarly, two circuit boards may be placed back to back but staggered one relative to the other and soldered to a D type connector having buckets or pins.

A ribbon cable may be cross wired and soldered to pads to make a more secure connection. Ribbon cables of 1.27 or 1.00mm pitch can be directly soldered to the circuit board and pinned out directly. Similarly, a ribbon cable or connector may be soldered to the circuit board and the 1.0mm or 0.8mm pitch pads cut to match the number of ways in a flexi-circuit socket into which the circuit board may be pushed to complete the connection.

The circuit board may similarly be cut in accordance with the number of SMT pads on an integrated circuit or other similar component mounted on to the circuit board. This may simply be done by juxtaposing the circuit board against the IC and soldering it to the pads. Probes may then be connected to the IC via the remaining connector positions.

Finally, two or four of the circuit boards may be held in place on a firm surface having first been cut so that the circuit pads exposed at the cut edge of the boards are of the same pitch as the leads on an IC. The IC may then be connected by any suitable means to the pads while allowing connections to be made to it via connection pads of larger pitch on the respective circuit boards.

It will of course be understood that the present invention has been described above purely by way of example, and modifications of detail can be made within the scope of the invention.

## Claims

1. A circuit board comprising an insulating substrate; a plurality of electrically conductive connection pads on the substrate, for electrical connection to another device, the pads being arranged in sets with a plurality of pads in each set; and circuit tracks on the circuit board electrically interconnecting a corresponding pad in each respective set; whereby the circuit board may be subdivided to provide desired circuit configurations.

2. A circuit board as claimed in claim 1 in which the pitch of the pads in at least two sets differs from one set to the other, and preferably the pitch of the pads is different in each set.

3. A circuit board as claimed in any of the preceding claims in which at least 3, preferably at least four, five, six or even more sets of pads are provided, and/or in which at least 3, or at least 5 or at least 10 or at least 20, pads are provided per set.

4. A circuit board as claimed in any of the preceding claims in which the tracks extend generally in the same direction along the circuit board, and/or in which the pads and tracks are provided on both faces of the circuit board.

5. A circuit board as claimed in any of the preceding claims in which the circuit board is thin enough to be cut by scissors so as to enable selective division of the circuit board, and/or in which the areas of the face or faces of the board not provided with pads or tracks are provided with solder resist.

6. A circuit board as claimed in any of the preceding claims in which the substrate is made of fibre glass, and/or in which the pads are of tin/lead solder, tin, nickel, gold or silver.

7. A circuit board as claimed in any of the preceding claims in which at least one further pad not electrically connected to any of the other pads or tracks is provided to enable a device to be mechanically attached to the circuit board.

8. A method of connecting a device to a circuit board as claimed in any of the preceding claims, comprising cutting the circuit board to a desired shape, and connecting the device to the circuit board, and preferably the device has at least one plurality of circuit connectors arranged substantially in a row of constant pitch and the circuit board has at least one set of pads having the same pitch as said pitch, and in the cutting step the circuit board is cut so as to expose at the cut edge an array of pads having the same pitch as the said pitch, and in the connecting step the circuit connectors are connected to the said pads.

9. An electrical assembly comprising at least one circuit board as claimed in any of claims 1 to 7 connected to a device, and preferably the electrical assembly comprises two circuit boards as claimed in any of claims 1 to 7 arranged back to back and inserted in a dual-in-line, insulation displacement connector header whereby to provide multiple interconnections.

10. A kit of parts comprising at least one circuit board as claimed in any of claims 1 to 7 and a device compatible with at least one such set of pads.
